Europäisches Patentamt

European Patent Office

Office européen des brevets

(11) Numéro de publication : **0 309 354 B1**

# (12) FASCICULE DE BREVET EUROPEEN

(45) Date de publication du fascicule du brevet :
04.03.92 Bulletin 92/10

(51) Int. Cl.⁵ : **C23C 14/56, C21D 9/00**

(21) Numéro de dépôt : **88402392.0**

(22) Date de dépôt : **22.09.88**

(54) Installation automatique de traitement thermochimique rapide.

(30) Priorité : **24.09.87 FR 8713217**

(43) Date de publication de la demande :
**29.03.89 Bulletin 89/13**

(45) Mention de la délivrance du brevet :
**04.03.92 Bulletin 92/10**

(84) Etats contractants désignés :
**AT BE CH DE ES GB GR IT LI LU NL SE**

(56) Documents cités :
**WO-A-87/04414**
**GB-A- 931 941**
**SU-A- 175 366**
**US-A- 3 238 918**
**US-A- 4 646 681**
**PATENT ABSTRACTS OF JAPAN, vol. 5, no. 45 (C-48)[717], 25 mars 1981; & JP-A-56 274 (HITACHI SEISAKUSHO K.K.) 06-01-1981**

(73) Titulaire : **STEIN HEURTEY**
**B.P. 69**
**F-91002 Evry Cedex (FR)**

(72) Inventeur : **Lebeaupin, Denis**
**1, Rue Alfred Savouré**
**F-94220 Charenton (FR)**
Inventeur : **Schwebel, Oliver**
**2, Square de la Borne**
**F-91000 Courcouronnes (FR)**

(74) Mandataire : **Armengaud Ainé, Alain**
**Cabinet ARMENGAUD AINE 3 Avenue Bugeaud**
**F-75116 Paris (FR)**

## Description

La présente invention est relative à une installation automatique de traitement thermochimique rapide d'une charge constituée de pièces destinées notamment à l'industrie mécanique.

Il est connu qu'en vue d'augmenter la dureté et la résistance à la fatigue de telles pièces, on leur fait subir un traitement thermochimique qui consiste à enrichir la matière constituant ces pièces avec des espèces chimiques déterminées telles que, par exemple, du carbone ou de l'azote, puis à les refroidir selon des cycles connus.

Les installations généralement utilisées pour réaliser ce type de traitement se présentent généralement sous la forme de lignes continues ou de fours à charges dans lesquels on effectue le chauffage et le traitement thermochimique dans une même enceinte, la trempe étant réalisée par immersion dans un bac relié à l'enceinte de traitement thermique, par l'intermédiaire d'un sas ou similaire. Généralement, les pièces à traiter sont disposées sur des plateaux, dans des paniers ou sur des tapis et ce mode de manutention présente l'inconvénient selon lequel les supports de pièces représentent couramment jusqu'à 50 % de la charge totale du four.

Afin de remédier aux inconvénients rencontrés dans la mise en oeuvre de telles installations connues, la présente titulaire a développé une installation automatisée de traitement thermochimique rapide de pièces notamment pour l'industrie mécanique, qui a fait l'objet de son brevet français N° 86 01 913 publié sous le numéro 2 594 102.

Cette installation automatisée comprend une pluralité de modules de traitement de pièces tels que notamment module de préchauffage, modules de traitement thermochimique, module de trempe, de moyens de chargement, des moyens de déchargement et des moyens pour assurer les transferts successifs des pièces à traiter aux différents modules, cette installation étant caractérisée notamment en ce que les pièces devant être traitées sont empilées en colonnes, sur lesquelles elles sont éventuellement séparées par des intercallaires et en ce que lesdits colonnes sont délivrées par un moyen d'alimentation à un poste de chargement, la colonne étant ensuite transférée au premier module de traitement à l'aide d'un sas de transfert et d'un moyen de manipulation.

La présente invention constitue un perfectionnement à cette installation et elle permet en particulier d'accroître la vitesse de traitement, notamment en facilitant les opérations de transfert des pièces à traiter entre les différents modules de traitement, grâce à la suppression du sas de transfert et à une nouvelle disposition des modules et des moyens permettant d'assurer un transfert rapide et fiable entre les différents modules, en fonction des exigences des traitements thermochimiques à réaliser.

En conséquence, la présente invention a pour objet une installation automatique de traitement thermochimique rapide d'une charge constituée de pièces, destinées notamment à l'industrie mécanique qui comprend une pluralité de modules de traitement tels que notamment module de préchauffage par induction, modules de traitement thermochimique, module de trempe, un moyen pour effectuer le chargement et le déchargement des pièces empilées en colonnes et un moyen de transfert desdites colonnes de pièces entre les différents modules de traitement, cette installation étant caractérisée en ce qu'elle comprend en outre :

– un plateau circulaire fixe sur la périphérie duquel sont répartis les différents modules de traitement, ceux-ci étant suspendus en-dessous de la surface inférieure dudit plateau, lequel comporte des ouvertures obturables de façon étanche pour l'introduction des pièces à traiter dans le modules respectifs et

– un disque mobile monté à rotation et de façon coaxiale au-dessus du plateau fixe, ce disque mobile recevant le moyen de transfert afin que ce dernier puisse être amené successivement au-dessus du poste de chargement/déchargement et des postes d'accès aux différents modules pour respectivement introduire dans l'installation une colonne de pièces à traiter ; faire passer ladite colonne successivement dans les différents modules et extraire de l'installation ladite colonne de pièces après traitement.

Selon une caractéristique de cette invention, le moyen de transfert est constitué d'au moins une enceinte étanche qui est fixée sur le disque mobile et qui comprend un système de préhension et de translation verticale des colonnes de pièces.

Selon un mode de réalisation préféré de la présente invention, le moyen de transfert comporte une enceinte triple comprenant une première partie, isolée thermiquement, pour recevoir la charge lors de son transfert à chaud, une seconde partie non isolée recevant la charge lors de son transfert à froid et une troisième partie dans laquelle est logé le système d'entrainement en translation verticale des colonnes de pièces.

Selon une caractéristique de l'invention, le moyen de chargement/déchargement comprend au moins un bras de chargement des piles de pièces à traiter ou des pièces traitées, ce bras étant animé d'un mouvement de rotation afin d'amener les pièces sous le plateau fixe au poste d'entrée de l'installation où elles sont prises en charge par le moyen de transfert afin d'assurer leur acheminement vers les modules de traitement.

Selon l'invention, le support des charges, positionné dans le moyen de transfert est animé d'un mouvement de translation verticale grâce à une vis à bille entraînée par un moteur de manière à pouvoir transférer les piles de pièces entre les différents modules, le transfert étant effectué par rotation du disque mobile supportant le moyen de transfert, la pile de pièces étant positionnée dans l'enceinte étanche du moyen de transfert, pendant ces opérations.

D'autres caractéristiques et avantages de la présente invention ressortiront de la description faite ci-après en référence aux dessins annexés qui en illustrent un exemple de réalisation dépourvu de tout caractère limitatif. Sur les dessins :

– La figure 1 est une vue en élévation et coupe partielle verticale d'un mode de réalisation préféré d'une installation selon l'invention ;

– La figure 2 est une vue en plan de la figure 1 et

– La figure 3 est une vue à échelle agrandie représentant un mode de réalisation préféré du moyen assurant le transfert des pièces à traiter.

En se référant aux dessins, on voit que l'installation objet de cette invention comprend essentiellement un plateau circulaire fixe 10 supporté par un socle 12 maintenu sur le sol et une pluralité de modules de traitement 14 qui sont disposés sous la surface inférieure du plateau circulaire fixe 10 à laquelle ils sont suspendus par des moyens classiques qui ne seront pas décrits ici. Au-dessus de ce plateau circulaire fixe 10 et coaxial à ce dernier est monté un disque circulaire rotatif 16 qui supporte le moyen de transfert 18 grâce auquel sont effectués d'une part le chargement et le déchargement des pièces à traiter de d'autre part le transfert de ces pièces entre les différents modules de traitement. L'installation comporte par ailleurs un système de chargement/déchargement désigné dans son ensemble par la référence 20. Ainsi qu'on l'a représenté sur le dessin, ce système de chargement/déchargement 20 est constitué ici par un bras 56 conçu de façon à recevoir les pièces qui sont traitées par lot. Chaque lot est constitué d'un empilage 22 de pièces, séparées ou non par des intercallaires, sur des colonnes support, de la manière décrite dans le brevet français mentionné ci-dessus. Bien entendu l'installation comporte en outre un poste de préparation et de démontage des piles de pièces. Ce poste étant de type connu, il ne sera pas décrit ici.

Selon l'invention, on peut prévoir un bras de chargement des piles de pièces au poste d'entrée de l'installation de traitement et un second bras identique pour assurer le déchargement des piles de pièces sortant de l'installation de traitement. Bien entendu, ces deux fonctions peuvent être assurées par un bras unique. On peut également utiliser un manipulateur cumulant ces deux fonctions avec celles de la préparation et du démontage des piles de pièces.

Les différents modules de traitement tels que 14 peuvent comprendre par exemple :

– un module de préchauffage par induction, dans lequel les pièces sont amenées à la température de traitement ;

– six modules de traitement thermochimique dans lesquels les pièces subissent un cycle de cémentation, diffusion et

– un module de trempe dans lequel les pièces sont refroidies par exemple par une circulation d'un fluide gazeux par exemple de l'azote sous pression ou non.

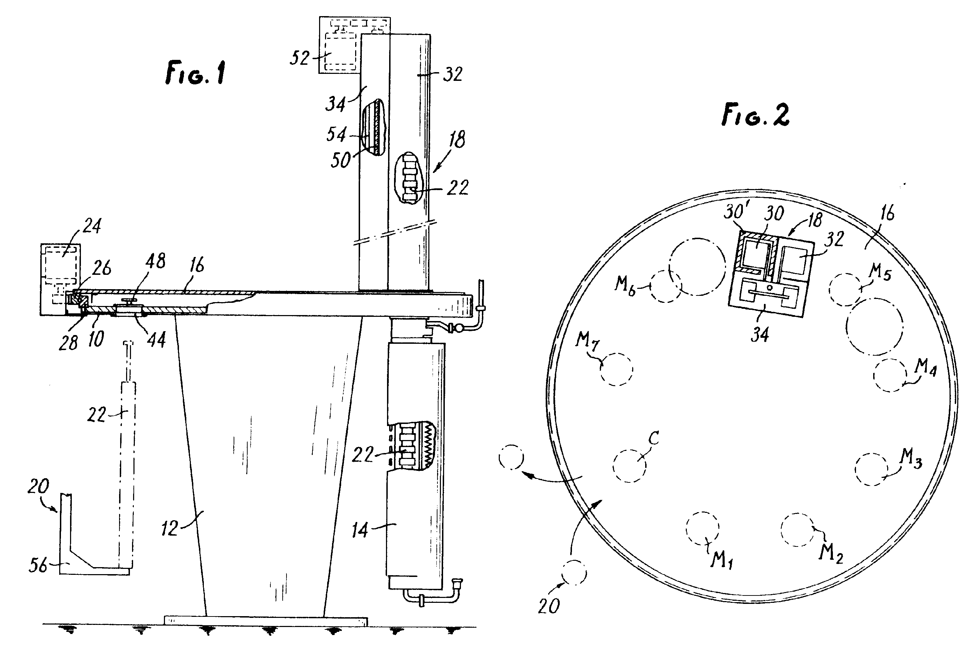

Sur la figure 2, ces différents modules ont été désignés par les références M1 à M7. Pour plus de détails, on pourra se référer à la description du brevet français mentionné ci-dessus.

Le disque mobile 16 recevant le moyen de transfert 18 est entraîné en rotation autour de son axe par l'intermédiaire d'un moteur 24 entraînant une couronne circulaire dentée 26. Un système de joint 28 assure l'étanchéité par rapport à l'installation et permet le maintien sous gaz neutre ou sous vide partiel de l'enceinte constituée par le plateau 10 et le disque 16.

Le moyen de transfert 18 se présente sous la forme d'une enceinte qui est fixée sur le disque mobile 16 et, dans cet exemple de réalisation non limitatif, cette enceinte de traitement est constituée par une chambre triple comprenant trois parties :

– une première partie 30 isolée thermiquement par un garnissage 30' qui reçoit la charge 22 lors de son transfert à chaud, cet isolant 30' permettant de limiter les déperditions calorifiques de la charge transportée, tout en assurant la protection du mécanisme d'entraînement situé dans la troisième partie décrite ci-après ;

– une seconde partie 32 non isolée destinée à recevoir la charge lors de son transfert à froid et

– une troisième partie 34 qui reçoit le mécanisme assurant la translation verticale des charges 22 de la manière décrite ci-après.

Selon l'invention, on prévoit un système annexe (non représenté sur le dessin) qui est positionné près du moyen de transfert 18 et qui est conçu de manière à assurer une obturation immédiate du module venant d'être déchargé afin d'éviter les déperditions thermiques.

Dans cet exemple de réalisation, le mécanisme assurant la translation des charges comprend un moteur d'entrainement 52, un support de charge 36 comportant un organe de préhension 38 permettant de saisir la colonne de pièces 22 de la manière décrite ci-après, ce support 36 étant entraîné en translation verticale grâce à une vis à bille 50 entraînée par le moteur 52, le guidage étant assuré par une tige verticale 54.

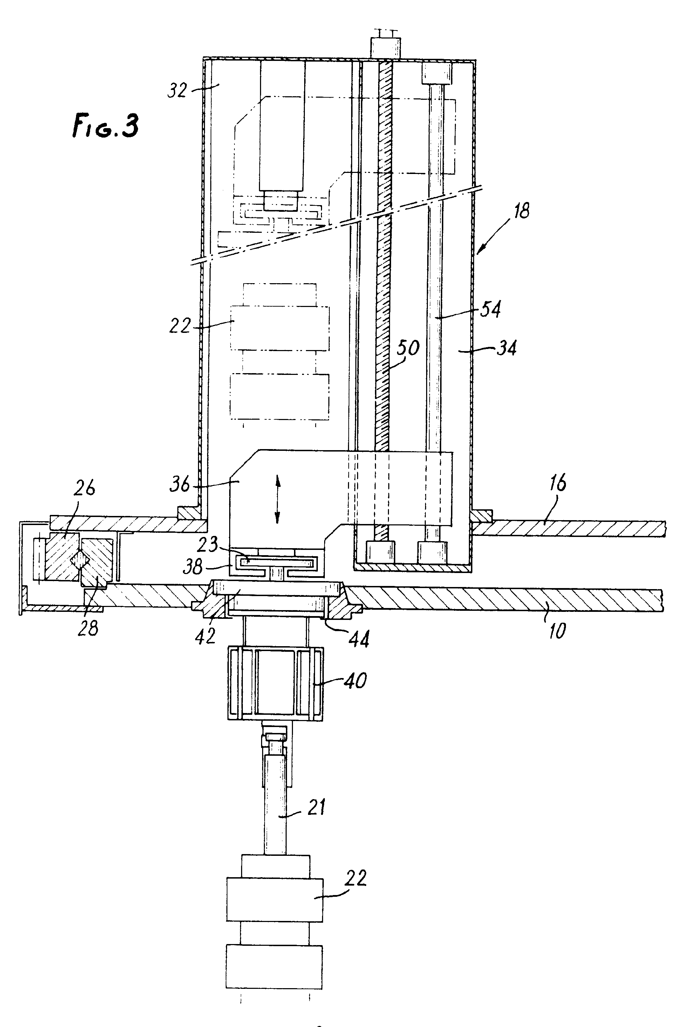

Ainsi qu'on le voit sur la figure 3, la colonne 22 de pièces à traiter empilées sur la colonne support 21, est manipulée, aux fins de transfert entre les différents modules, par le support 36, grâce à l'organe de préhension 38 de ce dernier, qui peut venir en prise sur une pièce 23 solidaire d'un bouchon d'obturation 42, lequel est monté à l'extrémité du support 40 de la pile 20.

Le fonctionnement de cette installation est le suivant :

Les pièces, après avoir été empliées sur leur colonne support 21 constituent des lots 22 qui sont amenés successivement au poste de chargement C grâce au bras de chargement 56. En regard du lot 22 ainsi amené devant l'installation est disposé un orifice de chargement 44, ménagé dans le plateau circulaire fixe 10 supportant les différents modules de traitement tels que 14, cet orifice de chargement 44 étant normalement obturé par un organe d'obturation tel que 48. La rotation du disque mobile 16 sous l'effet du moteur 24 entraînant la couronne dentée 26, permet d'amener le moyen de transfert 18 au dessus de l'ouverture 44. La commande du moteur 52 permet de faire descendre le bras support 36 et son organe de préhension 38, de manière que ce dernier saisisse le lot 22 des pièces à traiter comme représenté sur la figure 3. Ce lot de pièces est ensuite transféré par le moyen de transfert 18, au poste de préchauffage, après que la charge 22 ait été positionnée à l'intérieur de l'une des enceintes 32 ou 30, prévues dans le moyen de transfert 18, grâce au déplacement en translation vers le haut du support 36 sous l'effet du moteur 52, et après rotation du disque mobile 16 de manière à amener le moyen de transfert 18 en regard de l'ouverture donnant accès au module de préchauffe. La charge peut ensuite être transférée de la même façon aux différents modules de traitement thermochimique puis au module de trempe. Le déchargement de la colonne de pièces constituant la charge 22 s'effectue de la même manière que le chargement, le mode de fonctionnement du moyen de transfert 18 et du bras de déchargement s'effectuant en sens inverse de ceui décrit ci-dessus pour le chargement.

A titre d'exemple, on a indiqué ci-après un cycle de traitement typique réalisé dans une installation selon l'invention.

Ce cycle est le suivant :

```
- préchauffage à 920°C

- cémentation sous basse pression à 920°C        : 5 mn

- diffusion sous vide à 920°C                    : 4 mn

- cémentation sous basse pression à 920°C        : 3 mn

- diffusion                                      : 19 mn

- trempe sous gaz
```

L'installation fonctionnant selon ce cycle permet de traiter 200 pièces par heure, chaque colonne comportant 20 pièces chacune.

A titre également d'exemple, on a indiqué ci-après un cycle typique de production d'une installation selon l'invention comportant six poste de cémentation, un poste de préchauffe et un poste de trempe. L'équilibre des flux entre les différentes étapes de traitement conduit aux temps de séjour suivants :

```
Temps de séjour          Préchauffe                  5 mn

                         Cémentation            33 mn 45 s

                         Trempe                  5 mn

                         Enceinte de transfert   1 mn 15 s
```

- Temps de séjour total
  dans l'installation ........................... 46 mn
- Temps consacré aux
  transferts ................................... 1 mn
- Temps entre deux chargements ...................................... 5 mn 45 s

La mise en oeuvre de l'installation selon la présente invention montre qu'entre la libération d'un module et son occupation par une nouvelle charge, il se produit trois transferts, soit 45 secondes. Ainsi, les taux d'occupation des modules sont respectivement de 85 % pour les modules de trempe et de préchauffe et de 98 % pour les modules de cémentation.

On constate que l'installation objet de la présente invention se caractérise par un rendement considérablement amélioré par rapport aux installations selon la technique antérieure, ceci grâce notamment à la diminution des temps de transfert résultant des caractéristiques originales du moyen de transfert 18 et également de la disposition nouvelle des différents modules de traitement.

Bien entendu la présente invention n'est nullement limitée aux différents exemples de réalisation décrits ou représentés ici mais elle en englobe toutes les variantes.

**Revendications**

1. Installation automatique de traitement thermochimique rapide d'une charge constituée de pièces, destinées notamment à l'industrie mécanique qui comprend une pluralité de modules de traitement tels que notamment module de préchauffage par induction, modules de traitement thermochimique, module de trempe, un moyen pour effectuer le chargement et la déchargement des pièces empilées en colonnes et un moyen de transfert desdites colonnes de pièces entre les différents modules de traitement, cette installation étant caractérisée en ce qu'elle comprend en outre :

un plateau circulaire fixe (10) sur la périphérie duquel sont répartis les différents modules de traitement (14), ceux-ci étant suspendus en-dessous de la surface inférieure dudit plateau, lequel comporte des ouvertures obturables de façon étanche pour l'introduction des pièces à traiter (22) dans les modules respectifs et

un disque mobile (16) monté à rotation et de façon coaxiale au-dessus du plateau fixe, ce disque mobile recevant le moyen de transfert (18) afin que ce dernier puisse être amené successivement au-dessus du poste de chargement/déchargement (C) et des postes d'accès aux différents modules pour respectivement introduire dans l'installation une colonne de pièces à traiter ; faire passer ladite colonne successivement dans les différents modules et extraire de l'installation ladite colonne de pièces après traitement.

2. Installation automatique selon la revendication 1, caractérisée en ce que le moyen de transfert (18) est constitué d'au moins une enceinte étanche qui est fixée sur le disque mobile et qui comprend un système de préhension (36-38) et de translation verticale des colonnes de pièces.

3. Installation automatique selon l'une des revendications 1 ou 2, caractérisé en ce que le moyen de transfert (18) comporte une enceinte triple comprenant une première, isolée thermiquement (30), pour recevoir la charge lors de son transfert à chaud, une seconde partie non isolée (32) recevant la charge lors de son transfert à froid et une troisième partie (34) dans laquelle est logé le système d'entraînement en translation verticale des colonnes de pièces.

4. Installation automatique selon l'une quelconque des revendications précédentes caractérisée en ce que le moyen de chargement/déchargement (20) comprend au moins un bras de chargement (56) des piles de pièces à traiter ou des pièces traitées, ce bras étant animé d'un mouvement de rotation afin d'amener les pièces sous le plateau fixe (10) au poste d'entrée de l'installation où elles sont prises en charge par le moyen de transfert (18) afin d'assurer leur acheminement vers les modules de traitement.

5. Installation automatique selon l'une quelconque des revendications précédentes caractérisée en ce que le chargement des piles de pièces au poste de chargement de l'installation et le déchargement des piles de pièces traitées sont assurés par un bras unique.

6. Installation automatique selon l'une quelconque des revendications précédentes, caractérisée en ce que le chargement des piles de pièces au poste de chargement de l'installation et le déchargement des piles de pièces traitées sont assurés par un manipulateur cumulant ces deux fonctions avec celles de préparation et de démontage des piles de pièces.

7. Installation automatique selon l'une quelconque des revendications précédentes caractérisée en ce qu'on prévoit un dispositif annexe situé près du moyen de transfert (18) de manière à obturer immédiatement le module venant d'être déchargé pour éviter les déperditions thermiques.

8. Installation automatique selon l'une quelconque des revendications précédentes caractérisée en ce que le support des charges (36), positionné dans le moyen de transfert (18) est animé d'un mouvement de translation verticale grâce à une vis à bille (50) entraînée par un moteur (52) de manière à pouvoir transférer les piles (22) de pièces entre les différents modules, le transfert étant effectué par rotation du disque mobile 16 supportant le moyen de transfert (18), la pile de pièces (22) étant positionnée dans l'enceinte étanche du moyen de transfert (18), pendant ces opérations.

## Patentansprüche

1. Automatische Vorrichtung zur schnellen thermochemischen Behandlung einer Charge aus Teilen, die insbesondere für die Maschinenbau-Industrie bestimmt sind, wobei die Vorrichtung eine Vielzahl von Bearbeitungsmodulen, insbesondere Induktions-Vorwärmmodule, thermochemische Bearbeitungsmodule und Abschreckmodule, eine Be- und Entladeeinrichtung für die zu Säulen gestapelten Teile, eine Einrichtung zum Transferieren der aus Teilen bestehenden Säulen zwischen den verschiedenen Bearbeitungsmodulen, umfaßt, dadurch **gekennzeichnet**, daß die Vorrichtung weiterhin umfaßt:
eine kreisrunde feste Platte (10), an deren Rand die verschiedenen Bearbeitungsmodule (14) verteilt sind, wobei diese unterhalb der unteren Oberfläche der Platte aufgehängt sind, die dicht verschließbare Öffnungen zur Einführung der zu bearbeitenden Teile (22) in die entsprechenden Module aufweist und
eine bewegliche drehbar und koaxial oberhalb der festen Platte angebrachte Scheibe (16), welche die Transfereinrichtung (18) mit dem Ziel aufnimmt, daß letztere nacheinander über die Be- und Entladestelle (C) und die Eingangsstellen an den verschiedenen Modulen geführt werden kann, zur entsprechenden Einführung der aus zu behandelnden Teilen bestehenden Säulen in die Vorrichtung, zum Durchschleusen der Säulen nacheinander durch die verschiedenen Module und zum Herausziehen der Säulen nach der Behandlung aus der Vorrichtung.

2. Automatische Vorrichtung nach Anspruch 1, dadurch **gekennzeichnet**, daß die Transfereinrichtung (18) mindestens aus einer dichten Einfassung besteht, die auf der beweglichen Platte befestigt ist und ein System zum Greifen (36, 38) und zum vertikalen Verschieben der aus zu behandelnden Teilen bestehenden Säulen umfaßt.

3. Automatische Vorrichtung nach einem der Ansprüche 1 oder 2, dadurch **gekennzeichnet**, daß die Transfereinrichtung (18) eine dreifach Einfassung aufweist, die einen ersten thermisch isolierten Bereich (30) zur Aufnahme der warmen Charge während ihres Transports, einen zweiten nicht-isolierten Bereich (32), der die kalte Charge während des Transports aufnimmt, und einen dritten Bereich (34), in dem das System zum vertikalen Verschieben der aus zu behandelnden Teilen bestehenden Säulen angeordnet ist, umfaßt.

4. Automatische Vorrichtung nach einem der vorhergehenden Ansprüche, dadurch **gekennzeichnet**, daß die Be- und Entladeeinrichtung (20) mindestens einen Ladearm (56) für die Stapel der zu behandelnden oder behandelten Teile umfaßt, wobei der Arm zu einer Drehbewegung veranlaßt wird, um die Teile unter die feste Platte (10) zur Eingangsstelle der Vorrichtung zu führen, wo sie von der Transfereinrichtung (18) mit dem Ziel übernommen werden, ihre Weiterleitung zu den Bearbeitungsmodulen sicherzustellen.

5. Automatische Vorrichtung nach einem der vorhergehenden Ansprüche, dadurch **gekennzeichnet**, daß das Laden der aus Teilen bestehenden Stapel an der Beladestelle der Vorrichtung und das Entladen der aus behandelten Teilen bestehenden Stapel durch einen einzigen Arm sichergestellt werden.

6. Automatische Vorrichtung nach einem der vorhergehenden Ansprüche, dadurch **gekennzeichnet**, daß das Laden der Stapel aus Teilen an der Beladestelle der Vorrichtung und das Entladen der Stapel aus behandelten Teilen durch einen Manipulator sichergestellt werden, der diese beiden Funktionen sowie den Zusammenbau und die Demontage der aus Teilen bestehenden Stapel selbst ausführen kann.

7. Automatische Vorrichtung nach einem der vorhergehenden Ansprüche, dadurch **gekennzeichnet**, daß man in der Nähe der Transfereinrichtung (18) eine Zusatzvorrichtung vorsieht, die den Modul nach der Entladung zur Vermeidung von Wärmeverlusten sofort verschließt.

8. Automatische Vorrichtung nach einem der vorhergehenden Ansprüche, dadurch **gekennzeichnet**, daß der in der Transfereinrichtung (18) angeordnete Chargenträger (36) durch eine Kugelgewindespindel (50) vertikal bewegt wird, wobei die Kugelgewindespindel (50) durch einen Motor (52) derart angetrieben wird, daß die Stapel (22) der Teile zwischen den verschiedenen Modulen transferiert werden können, der Transfer durch die Rotation der beweglichen Scheibe (16) erreicht wird, welche die Transfereinrichtung (18) trägt, und die Stapel aus Teilen (22) während dieser Operationen in den dichten Einfassungen der Transfereinrichtung (18) angeordnet sind.

## Claims

1. Automatic installation for the rapid thermochemical treatment of a charge constituted by parts more particularly intended for the mechanical industry, which comprises a plurality of treatment modules, such as an induction preheating module, thermochemical treatment modules, a hardening module, a means for loading and unloading parts stacked in the form of columns and a means for transferring said columns of parts between the different treatment modules, said installation being characterized in that it also comprises

a fixed circular plate (10) on whose periphery are distributed the different treatment modules (14), the latter being suspended below the lower surface of the plate, which has openings tightly sealable for the introduction of the parts (22) to be treated into the respective modules and

a mobile disk (16) mounted in rotary and coaxial manner above the fixed plate, said mobile disk receiving the transfer means (18), in order that the latter can be successively brought above the loading/unloading station (C) and access stations to the different modules in order to respectively introduce into the installation a column of parts to be treated, said column being successively passed into the different modules and, following treatment, said column of parts is extracted from the installation.

2. Automatic installation according to claim 1, characterized in that the transfer means (18) is constituted by at least one tight enclosure, which is fixed to the mobile disk and which comprises a system (36-38) for the gripping and vertical translation of the columns of parts.

3. Automatic installation according to one of the claims 1 or 2, characterized in that the transfer means (18) has a triple enclosure comprising a first, thermally insulated enclosure (30) for receiving the charge during its hot transfer, a second, uninsulated enclosure (32) receiving the charge during its cold transfer and a third enclosure (34) in which is housed the drive system for the vertical translation of the columns of parts.

4. Automatic installation according to any one of the preceding claims, characterized in that the loading/unloading means (20) comprises at least one loading arm (56) for stacks of parts to be treated or treated parts, said arm performing a rotary movement in order to bring the parts beneath the fixed plate (10) at the intake station of the installation, where they are taken up by the transfer means (18), in order to ensure their travel to the treatment modules.

5. Automatic installation according to any one of the preceding claims, characterized in that the loading of the stacks of parts at the loading station of the installation and the unloading of the stacks of treated parts are ensured by a single arm.

6. Automatic installation according to any one of the preceding claims, characterized in that the loading of the stacks of parts at the loading station of the installation and the unloading of the stacks of treated parts are ensured by a manipulator combining these two functions with those of preparing and dismantling the stacks of parts.

7. Automatic installation according to any one of the preceding claims, characterized in that a supplementary device is provided located close to the transfer means (18), so as to immediately seal the module which has just been discharged in order to prevent heat losses.

8. Automatic installation according to any one of the preceding claims, characterized in that the support of the charges (36) positioned in the transfer means (18) performs a vertical translatory movement as a result of a ball screw (50) driven by a motor (52), so as to be able to transfer the stacks (22) of parts between the different modules, the transfer being carried out by the rotation of the mobile disk (15) supporting the transfer means (18), the stack of parts (22) being positioned in the tight enclosure of the transfer means (18) during these operations.

Fig.1

Fig.2

EP 0 309 354 B1

Fig.3